# EUROPEAN PATENT APPLICATION

(11) **EP 4 335 949 A1**
(43) Date of publication of application: **13.03.2024**
(21) Application number: 22194558.7
(22) Date of filing: 08.09.2022
(51) Int. Cl.: C30B 25/02, C23C 16/02, C23C 16/40, C23C 16/455, C30B 25/18, C30B 25/20, C30B 27/00, C30B 29/16, C30B 33/02, C30B 35/00, H01L 21/02, C30B 25/14, C30B 25/16

(54) **METHOD FOR GROWING A GALLIUM OXIDE LAYER ON A SUBSTRATE AND SEMICONDUCTOR WAFER**

(71) Applicant: Siltronic AG, 81677 München (DE); Leibniz-Institut für Kristallzüchtung im Forschungsverbund Berlin e.V., 12489 Berlin (DE)
(72) Inventor: Häckl, Walter, 84558 Kirchweidach (DE); Chou, Ta-Shun, 13587 Berlin (DE); Popp, Andreas, 15732 Eichwalde (DE); Bin Anooz, Saud, 12524 Berlin (DE)

(57) **Abstract**

A method of growing a layer of β-Ga₂O₃ on a substrate comprising the following steps: Polishing the substrate to a roughness of not more than 300 × 10⁻¹² m measured by AFM, etching the substrate using an aqueous solution of phosphoric acid (H₃PO₄) for not less than 12 min and not more than 20 min, the aqueous solution having a phosphoric acid concentration of at least 85% by volume, annealing the substrate at not less than 850°C and not more than 950°C in an atmosphere consisting essentially of high purity oxygen, metalorganic vapor phase epitaxy in an apparatus for metalorganic vapor phase epitaxy (MOVPE) comprising a shower head through which a gas stream is directed to the surface of the substrate, and wherein a distance between the shower head and the surface of the substrate is set wherein the gas stream comprises the components triethylgallium (TEGa), high purity oxygen and high purity argon, characterized in that the distance between the shower head and the surface of the substrate is more than 10 mm and less than 15 mm, and the proportionate gas flow of the high purity argon is not less than 3000 sccm and not more than 10000 sccm and the molar ratio of the high-purity oxygen and triethylgallium (TEGa) is more than 300 and less than 400.

## Description

### FIELD

The present invention relates to a method for growing a layer of β-Ga₂O₃ on a substrate with improved electrical properties and a substrate having a layer essentially made of β-Ga₂O₃.

### BACKGROUND

The semiconductor material β-Ga₂O₃ possesses an ultrawide bandgap of ~4.9 eV with a theoretically predicted critical electric field up to 8 MV/cm and room-temperature electron mobility of 200 cm²V⁻¹s⁻¹, which results in a two to three times higher Baliga's figure of merit for β-Ga₂O₃ compared to other power electronic semiconductors such as SiC and GaN. The demonstration of high-quality bulk β-Ga₂O₃ single crystals growing from the melt using various techniques, such as the Czochralski method, the floating zone techniques, edge-defined film-fed growth (EFG), and the vertical Bridgman method, is one of the critical advantages attracting significant interest from both academic and industrial for its potentials in mass production with a lower cost and the growth of homoepitaxial films.

Homoepitaxial-grown β-Ga₂O₃ thin-film of different substrate orientations via several growth methods, including molecular beam epitaxy (MBE), metalorganic vapor phase epitaxy (MOVPE), halide vapor-phase epitaxy (HVPE), and low-pressure chemical vapor deposition (LPCVD) has been investigated. Among all mentioned growth techniques, MOVPE (or MOCVD) epitaxy is an industrially preferred growth method due to its advantages of relatively high growth rate and the application scenario for mass production. The development of MOVPE-grown β-Ga₂O₃ thin-film has demonstrated great success in reaching high mobility without intentional doping for the (010) orientation. However, for the (100) orientation, a low doping regime (below 10¹⁷ cm⁻³) was not successfully demonstrated yet due to the epitaxy challenges like structural defect and the growth mode controlling, which limits its application for the vertical power device.

Chou et al. (T.-S. Chou, P. Seyidov, S. Bin Anooz, R. Grüneberg, T. Thi Thuy Vi, K. Irmscher, M. Albrecht, Z. Galazka, J. Schwarzkopf, and A. Popp, AIP Adv. 11, 115323 (2021) shows that a lower VI/III ratio plays a critical role in forming a stable Ga wetting layer (or Ga adlayer) on the surface of (100) β-Ga₂O₃, which helps maintain desired step-flow growth mode even at µm-level thickness.

A conventional and intuitive approach to tuning the VI/III ratio is through adjusting the flow rates of the Ga precursor and the oxidant species. However, due to the complicated gas-phase transport mechanism and the limited precision of the mass flow control in the MOVPE reactor, the exact VI/III ratio can be very different by changing any single parameter slightly, which results in a narrow growth window and limited space for further optimization.

### PROBLEM DESCRIPTION

The inventors realized that growing a layer of unintentionally doped β-Ga₂O₃ having a thickness of more than 2 µm parasitic particles were found to be pronounced.

On the one hand, such particles induce harmful, acceptor-like structural defects within the layer, which drops mobility down (even in some cases, Hall measurement is impossible). On the other hand, in vertical device structure, it enhances reverse leakage current, which means blocking capability of Schottky barrier deteriorates. Therefore, detailed investigations and process optimizations are needed to overcome the origin of such parasitic particles and how to eliminate them entirely.

It is an objective of the present invention to provide an improved method that does not exhibit these problems. It is also an objective of the present invention to provide an improved material that also eliminates these problems.

The objectives are solved by the methods and products described in the claims.

### BRIEF DESCRIPTION OF THE DRAWINGS

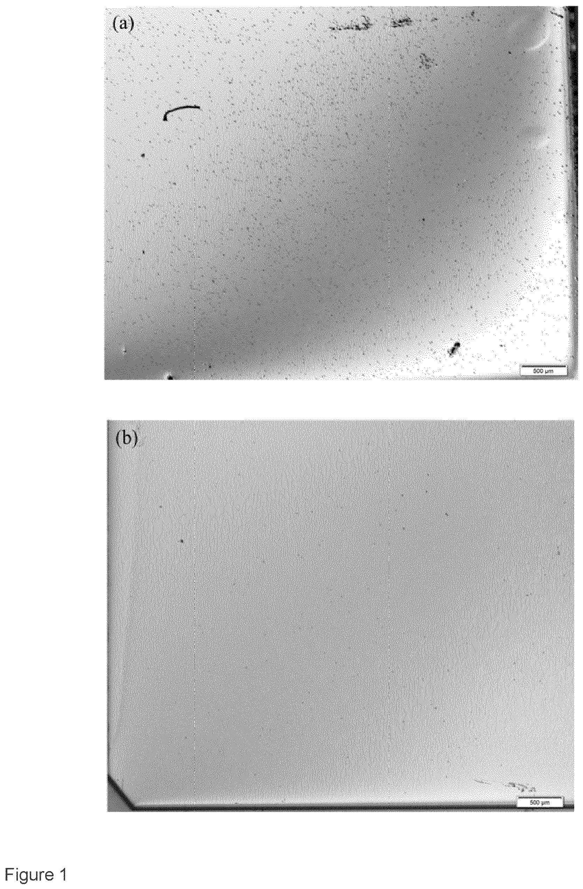

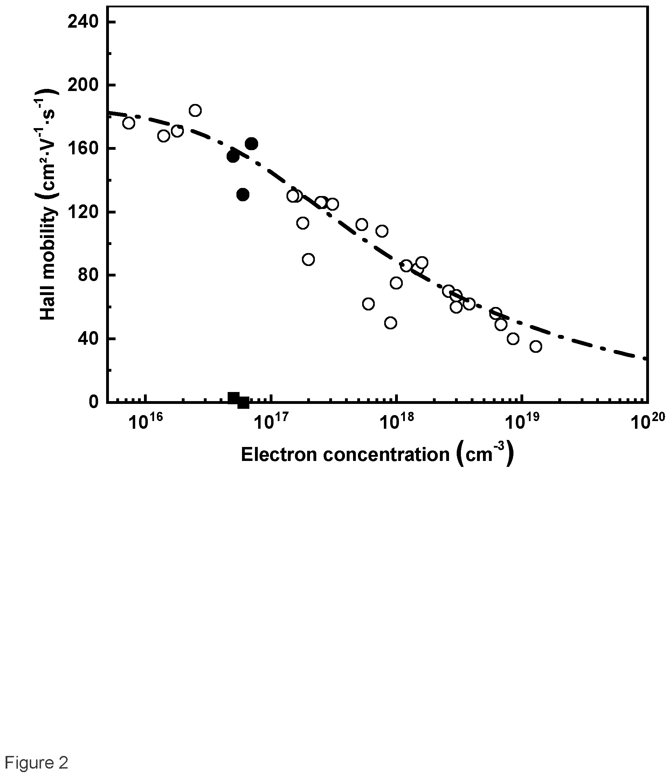

**Figure 1**
   A comparison of light microscopy images of the films grown under different showerhead distances: (a) 80 mm and (b) 15 mm. It is clearly visible that the lower distance of the showerhead to the surface of the substrate (b) creates less particles on the surface. The scale shown on the lower right corner in both Figures 1a and 1b represents a length of 500 µm.
**Figure 2**
   The electron Hall mobility of several samples of different origin using different techniques is show in this figure. Values being represented by open circles have a layer thickens of below 2 µm. The values for the electron Hall mobility represented by the closed squares represent experiments samples with a higher layer thickness (well above 2 µm) using the method which is known in the art.

The closed circles, however, represent values for the electron hall mobility with a higher layer thickness which were produced using the inventive method.

The dash dotted line represents an empirical behavior of the Hall mobility versus electron concentration.

### DETAILED DESCRIPTION

Layers of β-Ga₂O₃ with a doping concentration of less than 5 × 10¹⁶ cm⁻³ (hence called unintentionally doped) and a crystal orientation of (100) were grown on both (100) Mg-doped semi-insulating substrates and Si-doped conductive substrates which were produced by the Czochralski method.

Preferably, the substrates are polished. More preferably, the roughness after polishing is not more than 300 pm measured by atomic force microscope (AFM). The measured value is the root mean square of the deviation of an average height measured AFM.

Preferably, after polishing the substrates are etched in an aqueous solution of phosphoric acid (H₃PO₄, preferably not less than 85 vol%) for at least 12 min and not more than 20 min. Best results were reached for 15 min to remove the damaged layer during the polishing.

After polishing, the substrates are preferably annealed in an atmosphere consisting essentially of high purity oxygen at a temperature of not less than 850°C and not more than 950°C for preferably at least 1 hour to pronounce the terraced surface structure.

The inventors used a metalorganic vapor phase epitaxy system comprising a vertical showerhead low-pressure reactor (Structured Materials Industries, Inc. -USA) equipped with a rotating susceptor, that was utilized to grow n-type β-Ga₂O₃ thin films. An example of the equipment used can be seen in US 6 289 842 B1.

Preferably, Triethylgallium (TEGa) is used as metalorganic precursors for Ga, while high purity O₂ (5N) is preferably used as the oxidant and high purity Argon (5N) as the carrier gas.

The preferred proportionate gas flow of the high purity argon is not less than 3000 sccm and not more than 10000 sccm. More preferably the proportionate gas flow is not less than 5000 sccm and not more than 8000 sccm.

Preferably, the molar ration of the high-purity oxygen and the triethylgallium is more than 300 and less than 400.

Preferably, the growth temperature is more than 800°C, preferred more than 825°C, and less than 850°C.

Preferably, after the growth of the layer the wafer is annealed at a temperature of more than 10 K and less than 30K above the used growth temperature for not less than 2 h and not more than 4 h.

Preferably, the ambient atmosphere for the said annealing essentially consists of Argon.

After the annealing process is finished preferably a second growth step is started. The thickness of the layer can be increased without worsening the quality of the grown layer.

The surface roughness of the grown films was characterized using atomic force microscopy (Bruker Dimension Icon, - the USA). The value for the surface roughness is given by the root mean square of a deviation of an average surface.

The layer thickness and the dopant concentration profile were determined by the secondary ion mass spectrometry (SIMS) performed by RTG Mikroanalyse GmbH Berlin. The electrical properties of unintentionally-doped (UID) (100) β-Ga₂O₃ thin films were characterized via temperature-dependent resistivity and Hall measurements (HMS 7504, Lake Shore) in the van der Pauw configuration.

Metal stack of Ti (50 nm)/Au (150 nm) ohmic contacts were deposited on the corners of the samples in vacuum under pressure of a few 10⁻⁶ mbar with electron beam evaporation. Afterwards, samples were subjected to a rapid thermal annealing at 470 °C for 1 min in N₂ atmosphere to achieve a low on-contact resistance. The temperature was varied from 20 K to 320 K and excitation currents of 10 nA-1 µA were used.

The inventors investigated the influence of the showerhead distance on the growth of β-Ga₂O₃ thin films.

They realized that the layer growth rate increases nearly double by decreasing the showerhead distance from 80 mm to 15 mm while keeping the TEGa flow rate constant.

**Table 1: Summary of some samples using different showerhead distances. Samples were all grown with a targeted thickness of around 3 µm. For these examples the growth temperature and the chamber pressure are kept constant at about 800 °C and 25 mbar, respectively.**

| Sample | Showerhead distance (mm) | TEGa flux (sccm) | Oxygen flux (sccm) | Ar pushgas (sccm) | Growth rate (nm/min) |
|---|---|---|---|---|---|
| I | 80 | 60 | 165 | 2900 | 5.5 |
| II | 15 | 60 | 165 | 2900 | 12 |

Since the growth in the condition used is mass transport-limited, the thin film growth rate was primarily limited by the TEGa flow rate.

The observed increase in thin-film growth rate suggested that a lower showerhead distance reduces the loss of TEGa during the gas-phase transportation from the showerhead to the susceptor.

The preferred distance between the shower head and the surface of the substrate is more than 10 mm and less than 15mm.

The inventors think, that since the oxygen amount remained constant, an increased growth rate indicates a lower VI/III ratio close to the surface compared with a higher showerhead distance, which is an advantage for the stability of the Ga wetting layer formation and helps to maintain step-flow morphology during the film growth.

The desired step-flow morphology along the [001] direction could be observed under the inventive growth conditions.

The surface roughness (RMS) was measured to be below 0.5 nm, which is lower than the MOVPE-grown (010) β-Ga₂O₃ at a similar thickness in both small (0.5 µm × 0.5 µm) and large scale (5 µm × 5 µm) AFM images.

It should be noted that the inventive growth condition can be adapted to both Mg-doped substrates and Si-doped substrates grown in the same chamber, which enables the applications in the lateral and vertical device.

Moreover, the inventors realized that a lower showerhead distance seems to minimize the unwanted gas phase reactions in the chamber by reducing the flight path of the precursor, which allows fewer parasitic particles to be formed, and a much cleaner grown surface can be observed.

A comparison between the films grown under different showerhead distances by light microscopy is presented in Figure 1.

The inventors found parasitic particles to be pronounced at a higher thickness of the thin film (> 2 µm). On the one hand, such particles induce harmful, acceptor-like structural defects within the layer, which drops mobility down (even in some cases, Hall measurement is impossible) which makes the material useless for device manufacturing.

In vertical device structure, it enhances reverse leakage current, which means blocking capability of Schottky barrier deteriorates. Therefore, detailed investigations and process optimizations are needed to understand the origin of such parasitic particles and how to eliminate them entirely.

Another embodiment of this invention is an inventive semiconductor wafer which comprises a substrate having a front surface and said front surface being provided with a semiconductor layer of thickness d consisting essentially of β-Ga₂O₃

Preferably, the doping concentration of the said layer is less than 5 × 10¹⁶ cm⁻³ measured by Hall measurement at room temperature using a van der Pauw measurement setup.

The Hall mobility for the said layer measured at room temperature is preferably greater than 120 cm²V⁻¹s⁻¹ and the thickness d is greater than 3 µm measured by SIMS.

More preferably, the surface particle density on the semiconductor layer is less than 900 cm⁻² where the measurement having been carried out with optical microscopy.

More preferably, a deviation of the thickness of the layer from the average thickness of the layer is less than 10% measured by ellipsometry and the surface roughness of the layer is no more than 600 pm measured by AFM. The surface roughness is expressed in the root mean square of the deviation of an average height of the AFM measurement.

More preferably, the substrate is essentially of β-Ga₂O₃ having an electrical resistivity of less than 5 × 10⁻² Ohmcm at room temperature.

The inventors realized that these substrates having the preferred layer of β-Ga₂O₃ suited very good to be used as a start material to build vertical devices.

More preferably, the crystalline orientation of the layer is (100).

Most preferably, the thickness d of the layer is greater than 3 µm and less than 6 µm. The measurement can be easily performed by a SIMS measurement.

## Claims

1. A method of growing a layer of β-Ga₂O₃ on a substrate comprising the following steps:
Polishing the substrate to a roughness of not more than 300 × 10⁻¹² m measured by AFM,
etching the substrate using an aqueous solution of phosphoric acid (H₃PO₄) for not less than 12 min and not more than 20 min, the aqueous solution having a phosphoric acid concentration of at least 85% by volume,
annealing the substrate at not less than 850°C and not more than 950°C in an atmosphere consisting essentially of high purity oxygen,
metalorganic vapor phase epitaxy in an apparatus for metalorganic vapor phase epitaxy comprising a shower head through which a gas stream is directed to the surface of the substrate, and wherein a distance between the shower head and the surface of the substrate is set
wherein the gas stream comprises the components triethylgallium, high purity oxygen and high purity argon,
**characterized in that**
the distance between the shower head and the surface of the substrate is more than 10 mm and less than 15 mm, and
the proportionate gas flow of the high purity argon is not less than 3000 sccm and not more than 10000 sccm
and the molar ratio of the high-purity oxygen and triethylgallium is more than 300 and less than 400.

2. Method according to claim 1, **characterized in that**
the gas flow of the high purity argon is not less than 5000 sccm and not more than 8000 sccm.

3. Method according to claim 1, **characterized in that**
the growth temperature is more than 800°C, preferred more than 825°C, and less than 850°C.

4. Method according to claim 1, **characterized in that**
after growth of the layer the wafer is annealed at a temperature of more than 10K and less than 30K above the growth temperature for not less than 2 h and not more than 4 h.

5. Method according to claim 4, **characterized in that**
a second growth step is started after the annealing.

6. A semiconductor wafer comprising a substrate having a front surface,
said front surface being provided with a semiconductor layer of thickness d consisting essentially of β-Ga₂O₃
and the doping concentration of the layer is less than 5 × 10¹⁶ cm⁻³ measured by Hall measurement at room temperature using a van der Pauw measurement setup **characterized in that**
the Hall mobility measured at room temperature is greater than 120 cm²V⁻¹s⁻¹ and the thickness d is greater than 3 µm measured by SIMS.

7. A semiconductor wafer according to claim 6, **characterized in that** the surface particle density on the semiconductor layer is less than 900 / cm² where the measurement having been carried out with optical microscopy.

8. A semiconductor wafer according to claim 6 or claim 7 **characterized in that** a deviation of the thickness from the average thickness is less than 10% measured by ellipsometry and the surface roughness of the layer is not more than 600 pm measured by AFM.

9. A semiconductor wafer according to any of claim 6 to claim 8, **characterized in that** the substrate is essentially of β-Ga₂O₃ having an electrical resistivity of less than 5 × 10⁻² Ohmcm at room temperature.

10. A semiconductor wafer according to any of claim 6 to claim 9, **characterized in that** the crystalline orientation of the layer is (100).

11. A semiconductor wafer according to claim 6, **characterized in that** the thickness d is greater than 3 µm and less than 6 µm measured by SIMS.
